# EUROPÄISCHE PATENTSCHRIFT

(11) **EP 2 627 942 B1**
(45) Veröffentlichungstag und Bekanntmachung des Hinweises auf die Patenterteilung: **08.07.2015**
(21) Anmeldenummer: 11771072.3
(22) Anmeldetag: 11.10.2011
(51) Int. Cl.: F21K 99/00, F21V 13/10, F21V 29/00, F21Y 101/02, F21Y 113/00, H01L 25/075, H01L 33/60, F21V 29/77, F21V 29/83

(54) **LED-STRAHLER MIT REFLEKTOR**
LED SPOTLIGHT HAVING A REFLECTOR
PROJECTEUR À DIODES ÉLECTROLUMINESCENTES DOTÉ D'UN RÉFLECTEUR

(30) Priorität: 25.11.2010 DE 102010061972; 15.10.2010 DE 102010042516
(43) Veröffentlichungstag der Anmeldung: 21.08.2013
(73) Patentinhaber: Tridonic Jennersdorf GmbH, 8380 Jennersdorf (AT)
(72) Erfinder: DERKITS, Christian, A-7535 St. Michael (AT)
(74) Vertreter: Rupp, Christian
(86) Internationale Anmeldenummer: PCT/EP2011/067673
(87) Internationale Veröffentlichungsnummer: WO 2012/049137

(56) Entgegenhaltungen:
- WO-A1-2008/011724
- WO-A1-2010/113098
- DE-A1-102007 054 206
- US-A1- 2008 030 993
- US-A1- 2008 310 158

## Beschreibung

LED-Strahler, insbesondere zur Erzielung einer Weisslichtbeleuchtung, sind aus dem Stand der Technik gut bekannt. Unter einem LED-Strahler ist dabei regelmäßig eine LED-Lichtquelle zu verstehen, die eine oder mehrere LEDs gleicher und unterschiedlicher Farbe aufweist, wobei das Licht der einen oder mehreren LEDs durch einen Reflektor die gewünschte Verteilung erhält.

Eine besondere Problematik tritt dabei auf, wenn als Lichtquelle LEDs mit unterschiedlichen Emissionsspektren verwendet werden. Es muss nämlich dafür gesorgt werden, dass es vor dem Austritt des Mischlichts von den verschiedenen LEDs aus dem Strahler zu einer ausreichenden Vermischung des Lichts kommt, so dass eine ausreichende Farbhomogenität des ausgestrahlten Lichts über den möglichst gesamten Winkelbereich des ausgestrahlten Lichts erzielt werden kann.

Das Problem der Farbhomogenität kann sich noch verstärken, wenn das Spektrum wenigstens einer der LEDs der LED-Lichtquelle durch eine in Abstand und/oder in Kontakt auf die LED aufgebrachte Farbkonversionsschicht teilweise in ein Licht mit anderen (normalerweise niederfrequenteren) Licht umgewandelt wird, das die Farbkonversionsschicht sozusagen eine dritte Lichtquelle darstellt, die mit dem von den LEDs ausgesandten Licht homogen vermischt werden muss.

Ein Strahler mit einer LED-Lichtquelle und einem Reflektor ist bereits bekannt aus der WO 02/5047472. Dort wird eine LED-Lichtquelle auf dem Reflektorboden angeordnet und ein Unterabschnitt des Reflektor-Innenvolumes aufgefüllt.

Die WO 2010/113098 A1 offenbart einen LED-Strahler aufweisend einen schüsselformigen Reflektor und mehrere LEDs, die innerhalb des Reflektors angeordnet sind. Der Reflektor umfasst einen hinteren Halsabschnitt, durch den eine Stecker-Einheit aufweisend elektrisch leitende Pins durchgeführt wird. Auf den LEDs ist eine Abdeckung vorgesehen, die als Lichtmischkammer ausgeführt ist. Die Unterseite der Lichtmischkammer, d.h. der Träger, auf welchem die LED-Module angeordnet sind, ist als reflektierende Schicht ausgestaltet. Die obere Oberfläche der Lichtmischkammer besteht aus einer streuenden Schicht, die das Licht teilweise reflektiert, södass das emittierte Licht in der Lichtmischkammer zum Teil gemischt wird, bevor es durch die streuende Schicht übermittelt wird. Dadurch kann die Farbhomogenität verbessert werden.

Die US 2008/310158 A1 offenbart eine LED-Leuchte mit einer um einen LED-Chip angeordneten und z.B. ringförmigen Seitenwand. Diese Seitenwand ist transparent und kann aus einem Material wie Glass, Kunststoff und/oder AlO2 bestehen. Das Material kann auch eine streuende Wirkung haben. Ein oberes Element ist oberhalb der Seitenwand vorgesehen und besteht aus einem reflektierenden Material, z.B. ist dieses Material mehr als 80% reflektierend.

Es ist daher Aufgabe der Erfindung, einen LED-strahler vorzuschlagen, der eine bessere Lichtmischung erzielt, um somit die Farbhomogenität zu verbessern.

Diese Aufgabe wird gelöst durch die Merkmale der unabhängigen Ansprüche. Die abhängigen Ansprüche bilden den zentralen Gedanken der Erfindung in besonders vorteilhafter Weise weiter.

Ein erster Aspekt der Erfindung betrifft einen LED-Strahler, vorzugsweise für Weisslicht, aufweisend:
- ein LED-Modul mit mehreren LED-Chips auf einem Träger,
- einen mit dem LED-Modul in thermischen Kontakt befindlichen Kühlkörper,
- einen die LED-Chips seitlich umgebenden Reflektor, und
- eine innerhalb des Reflektors angeordnete, die LED-Chips seitlich umgebende Lichtmischkammer,
wobei die Lichtmischkammergrundfläche und der Reflektorboden auf der gleichen Ebene liegen die den LED-Chips zugewandte Seite der Lichtmischkammer reflektierend oder reflektierend und streuend ausgeführt ist, und die Lichtmischkammer durch eine Streuscheibe abgedeckt oder offen ist.

Der Reflektorboden kann eine zentrale Öffnung aufweisen, durch die die LED-Chips ausgehend von dem unterhalb des Reflektorbodens angeordneten Trägers des LED-Moduls in die Lichtmischkammer ragen.

Von dem Reflektorboden kann sich ein vorzugsweise einstückig damit ausgebildeter Zylinderansatz wegerstrecken, der die Lichtmischkammer umgibt.

Die Lichtmischkammer und der Reflektor können auf dem Träger des LED-Moduls aufgesetzt sein.

Die Lichtmischkammer und der Reflektor können separat oder integriert ausgestaltet sein.

Die LED-Chips können mit einem Farbkonversionsschicht abgedeckt sein.

Die LED-Chips können mit einem bspw. durch ein Dispensverfahren aufgebrachten Globe-Top oder einer anderen Abdeckung abgedeckt sein.

Die LED-Chips können monochromatische gleichfarbige oder verschiedenfarbige LED-Chips sein.

Die LED-Chips können aufweisen:
- wenigstens eine blaue oder UV LED aufweisen, deren Licht durch eine Farbkonversionsschicht, die oberhalb und vorzugsweise in direktem Kontakt mit sämtlichen LEDs angeordnet ist, teilweise in Licht mit anderer Wellenlänge umgesetzt wird, wobei das Mischlicht vorzugsweise im weissen Spektrum liegt, und
- wenigstens eine weitere LED, deren Licht im wesentlichen durch die Farbkonversionsschicht nicht umgesetzt wird.

Die innere Mantelfläche des Reflektors und/oder die Lichtmischkammer kann/können einen parabolischen oder eine geradlinigen Verlauf aufweisen oder wenigstens teilweise in Form von Facetten ausgebildet sein.

Die innere Mantelfläche des Reflektors kann reflektierend und/oder streuend ausgebildet sein. Beispielsweise können die innere Mantelfläche des Reflektors und die den LED-Chips zugewandte Seite der Lichtmischkammer metallbeschichtet sein, eine reflektive Beschichtung (weiss) aufweisen, Facetten aufweisen etc.

Der Reflektorboden und/oder die Grundfläche der Mischkammer kann/können kreisförmig, elliptisch oder quadratisch geformt sein.

Der Reflektor kann durch eine Streuscheibe abgedeckt oder offen sein.

Die Lichtmischkammer und/oder der Reflektor kann/können durch eine Farbkonversionsscheibe abgedeckt sein.

Der LED-Strahler kann als Deckenstrahler zum Einbau in abgehängten Decken ausgebildet sein.

Der LED-Strahler kann als Retrofit LED-Reflektor Lampe ausgebildet sein und bspw. mit einer handelsüblichen Fassung wie bspw. E27, E14 etc. ausgerüstet sein.

Der Kühlkörper kann eine zentrale Vertiefung zur Aufnahme des LED-Moduls aufweisen.

Der der Kühlkörper kann vorzugsweise in Form von Kühlrippen der Aussenseite des Reflektors wenigstens teilweise in flächigem Kontakt folgen.

Ein weiterer Aspekt betrifft einen LED-Strahler, vorzugsweise für Weisslicht aufweisend:
- ein LED-Modul mit mehreren LED-Chips auf einem Träger,
- einen mit dem LED-Modul in thermischen Kontakt befindlichen Kühlkörper,
- einen die LED-Chips seitlich umgebenden Reflektor, und
- eine innerhalb des Reflektors angeordnete, die LED-Chips eitlich umgebende Lichtmischkammer,
wobei sich von dem Reflektorboden ein vorzugsweise einstückig damit ausgebildeter Zylinderansatz wegerstreckt, der die Lichtmischkammer direkt oder indirekt umgibt.

Ein noch weiterer Aspekt betrifft einen LED-Strahler, vorzugsweise für Weisslicht, aufweisend:
- ein LED-Modul mit mehreren LED-Chips auf einem Träger,
- einen mit dem LED-Modul in thermischen Kontakt befindlichen Kühlkörper,
- einen die LED-Chips seitlich umgebenden Reflektor , und
- eine innerhalb des Reflektors angeordnete, die LED-Chips, seitlich umgebende Lichtmischkammer,
wobei die Lichtmischkammerwände und der Reflektorboden auf den Träger des LED-Moduls (direkt) aufgesetzt sind.

Die Erfindung betrifft schliesslich auch ein Verfahren zur Verbesserung der Farbhomogenität eines Weisslicht LED-Strahlers, aufweisend die Schritte:
- Vormischung von Licht von mehreren LEDs und optional von Farbkonversionsmaterial in einer von reflektierenden Wänden seitlich begrenzten und zum Teil nicht gefüllten Lichtmischkammer, wobei die den LED-Chips zugewandte Seite der Lichtmischkammer reflektierend oder reflektierend und streuend ausgeführt ist,
- Leiten des Lichts aus der offenen oder durch eine streuscheibe abgedeckten Lichtmischkammer in das Innenvolumen eines Reflektors, der das Licht an seiner Austrittsseite ausgibt.

Weitere Merkmale, Vorteil und Eigenschaften der Erfindung werden nunmehr unter Bezugnahme auf die Figuren der beiliegenden Zeichnungen näher erläutert werden.
- Figur 1: zeigt eine Querschnittsansicht eines erfindungsgemässen LED-Strahlers.
- Figur 2: zeigt den Kühlkörper und den Reflektor des LED-Strahlers,
- Figur 3: zeigt im Detail den Kühlkörper
- Figur 4: zeigt eine auseinandergenommene Ansicht von Reflektor, Mischkammerwand, LED-Modul und Kühlkörper, und

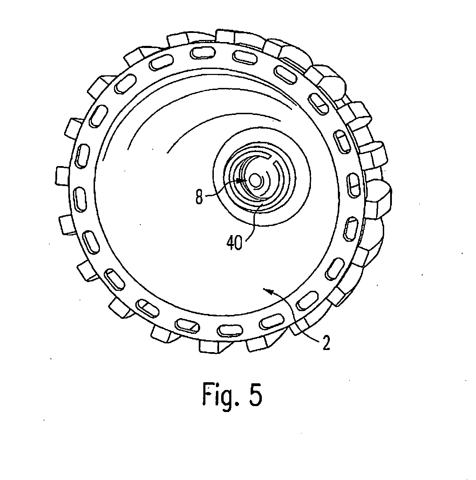

- Figur 5: zeigt den Reflektor mit von unten durchgesteckten, mit einer Dispensschicht überzogenen LEDs.

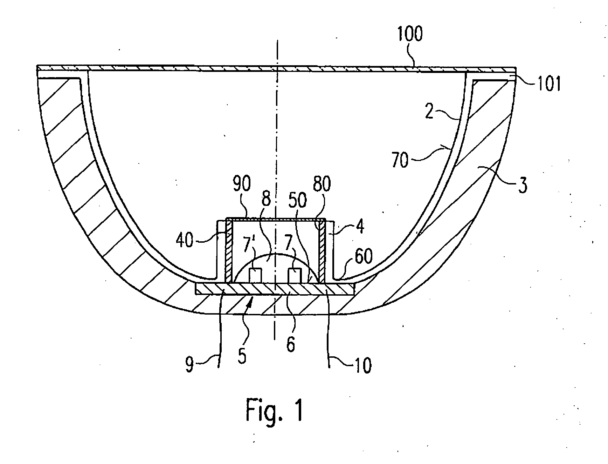

Figur 1 zeigt eine Querschnittsansicht eines erfindungsgemässen LED-Strahlers. Die LED-Lichtquelle wird vorzugsweise durch mehrere LEDs 7, 7' gebildet, die auf einen Träger 50 angeordnet sind, um somit ein LED-Modul 6 zu bilden.

Das LED-Modul 6 ist in thermischen Kontakt mit einem Kühlkörper 3. Im dargestellten Beispiel ist das LED-Modul 6 und genauer gesagt der Träger 5 in einem Zentralbereich des in der Schnittansicht fächerförmig ausgeführten Kühlkörpers 3 aufgesetzt oder vorzugsweise in eine zentrale Vertiefung des Kühlkörperbodens eingelassen.

Im dargestellten Beispiel ist in direktem Kontakt mit einem oder allen LEDs 7, 7' eine durch ein Dispensverfahren aufgebrachte durchlässige Schicht 8 aufgebracht, die Farbkonversionsmaterial und/oder Streupartikel enthalten kann.

Unter Farbkonversionsmaterial ist dabei im Rahmen der vorliegenden Beschreibung und Ansprüche ein oder mehrere Farbkonversionsstoffe zu verstehen. Diese Farbkonversionsstoffe können bspw. grün, gelb, gelb/grün, rot oder eine beliebige Mischung von zwei oder mehr dieser Farbkonversionsstoffe gleicher und/oder unterschiedlicher Farbe sein.

Das LED-Modul 6 ist wie dargestellt derart angeordnet, dass es von außen durch eine zentrale Öffnung dem Boden 60 eines Reflektors 2 hindurchgesteckt wird, derart, dass zumindest ein Teil der LEDs 6, 7' vorzugsweise aber.die gesamte Seitenfläche der LEDs 7, 7' in das Innere des Reflektors 2 hineinragt. Die LEDs 7, 7' sind von einer Lichtmischkammer 40 umgeben.

Die Lichtmischkammer weist vorzugsweise reflektierende Mischkammerwände 40 auf, die im dargestellten Beispiel als eigenständiges, beispielsweise ringförmiges Bauteil innen in einem dargestellten Beispiel einstückig mit dem Reflektorboden 60 ausgeführten Zylinderansatz 4 des Reflektors 2 ausgebildet sind. Alternativ können die Mischkammerwände 40 streuend und/oder streuend-reflektierend ausgeführt werden.

Die Mischkammerwände 40 und der Reflektor 2 sind auf dem Träger 6 des LED-Moduls 5 aufgesetzt. Die Böden der Mischkammer und des Reflektors liegen gemäss dem dargestellten Ausführungsbeispiel auf einer Ebene, sind also in der Seitenansicht fluchtend angeordnet.

Alternativ (nicht dargestellt) kann die Lichtmischkammer nach hinten versetzt sein. In diesem Fall ist also der Boden der Mischkammer bzgl. des Reflektorbodens nach hinten versetzt. Auch die LEDs können sämtlich hinter der durch den Reflektorboden gebildeten Ebene liegen. Bspw. kann die in Lichtabstrahlrichtung gelegene Auslassseite der Mischkammer auf der Ebene des Reflektorbodens liegen, oder leicht in den Reflektor-Innenraum hineinragen.

Die Mischkammerwände 40 können von der Dispensschicht 8 seitlich beabstandet sein, oder mit dieser in Kontakt stehen.

Die Mischkammer ist zum Teil unbefüllt, enthält also eine Luftschicht zwischen den LEDs 7, 7' bzw. der optionalen Dispensschicht 8 und der Austrittebene (definiert durch den Rand der Mischkammerwände).

Die Innenseite der die Lichtmischkammer begrenzenden Wände (im Beispiel 40) ist vorzugsweise reflektierend und/oder streuend ausgeführt. In der Lichtmischkammer wird es somit zu einer Vormischung des Lichts von den LEDs 7, 7' und gegebenenfalls des Farbkonversionsmaterials in Dispensschicht 8 kommen, bevor dieses Mischlicht das eigentliche Reflektorinnenvolumen begrenzt durch die innere Mantelfläche 70 des Reflektors 2 erreicht.

Wie in Fig. 1 schematisch dargestellt, kann die Lichtmischkammer in der Lichtabstrahlrichtung der LEDs 7, 7' durch eine lichtdurchlässige Abdeckung 90 begrenzt sein, die Konversionsmaterial und/oder neue Partikel enthalten kann.

Diese Abdeckung 90 ist also somit ein Beispiel, dass Farbkonversionsmaterial in Lichtabstrahlrichtung, aber in Abstand zu den LEDs 7, 7' angeordnet sein kann. Zwischen diesem Farbkonversionsmaterial und den LEDs 7, 7' kann sich ein nicht ausgefüllter, also nur Luft enthaltender Mischraum befinden.

Die Dispensschicht 8 ist dafür nur ein Beispiel, wie Farbkonversionsmaterial und/oder Streumaterial in direktem Kontakt mit wenigstens einer oder auch allen LEDs 7, 7' vorgesehen sein kann.

Alternativ oder zusätzlich kann auch der Reflektor 2 insgesamt durch eine lichtdurchlässige Abdeckung 100 in Lichtabstrahlrichtung abgeschlossen sein, wobei diese Abdeckung 100 ebenfalls Konversionsmaterial und/oder Streumaterial enthalten kann.

Wie bereits aus der Querschnittsansicht von Fig. 1 ersichtlich, kann der vorzugsweise becherförmig ausgestaltete Kühlkörper 3 dem Verlauf der Außenkontur des Reflektors 2 folgen. Der Rand des Reflektors 2 kann in einem Flanschbereich 101 enden, der oben den Kühlkörper 3 abdeckt. Wie in Fig. 1 schematisch dargestellt, kann die elektrische Versorgung der LEDs 7, 7' durch den Kühlkörperboden hindurch mittels elektrischer Kontaktierungen 9, 10 erfolgen.

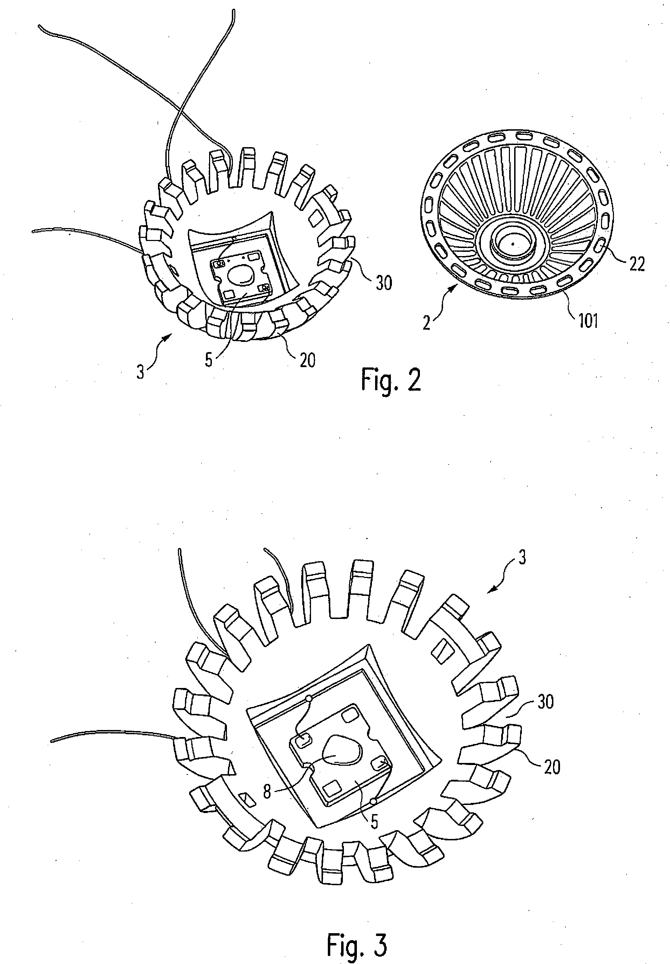

In Fig. 2 sind separat dargestellt der Kühlkörper 3 sowie der Reflektor 2.

In eine zentrale, hier im Wesentlichen quadratische Vertiefung des Kühlkörpers 3 ist wie dargestellt das LED-Modul 5 aufgenommen.

Die Seitenwand des becherförmigen Kühlkörpers 3 weist Kühlrippen 20 auf, die durch kaminartige Hohlräume 30 beabstandet sind. Zumindest in einem unteren Bereich (d.h. in Richtung der geschlossenen Grundfläche) können die Kühlrippen 20 durch radial nach innen versetzte Wandflächen verbunden sein. Im oberen Bereich können die Kühlrippen fingerartig freistehen, derart, dass also teilweise in seitlicher Ansicht die Reflektor-Aussenwand nach Aussen freiliegt.

Wie in Fig. 2 ebenfalls ersichtlich, weist der Flanschbereich 101 des Reflektors Ausnehmungen 22 auf, die vorzugsweise fluchtend zu den kaminartigen Ausdehnungen 30 des Kühlkörpers angeordnet werden, um (wenn der Reflektor in dem becherartigen Kühlkörper 3 eingesetzt ist), um die beispielsweise durch Konvektion geförderte Luftzirkulation in diesen kaminartigen Ausnehmungen 30 des Kühlkörpers 3 nicht zu blockieren.

Fig. 3 ist eine detaillierte Ansicht des becherförmigen Kühlkörpers 3.

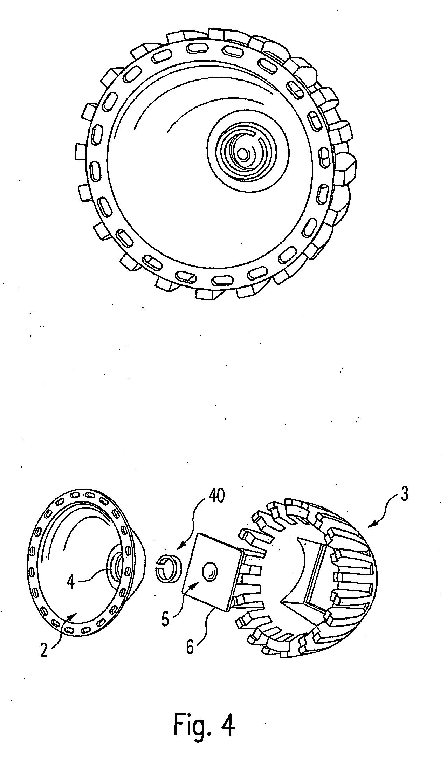

In Fig. 4 ist in einer auseinandergenommenen Ansicht zu sehen, dass die Mischkammerwand 40 als separates Bauteil beispielsweise in den Zylinderstutzen 4 des Reflektors 2 eingesetzt und auf den Träger 6 des LED-Moduls 5 aufgesetzt werden kann.

Insgesamt kann wie in Fig. 4 gut ersichtlich der Reflektor auch auf den Träger 6 des LED-Moduls 5, die LEDs 6, 7 umgebend aufgesetzt werden.

## Patentansprüche

1. LED-Strahler, vorzugsweise für Weisslicht, aufweisend:
- ein LED-Modul (5) mit mehreren LED-Chips (7, 7') auf einem Träger (6),
- einen mit dem LED-Modul (5) in thermischen Kontakt befindlichen Kühlkörper (3),
- einen die LED-Chips (7, 7') seitlich umgebenden Reflektor (2), und
- eine innerhalb des Reflektors (3) angeordnete, die LED-Chips (7, 7') seitlich umgebende Lichtmischkammer (40), wobei die Lichtmischkammergrundfläche (50) und der Reflektorboden (60) auf der gleichen Ebene liegen, die den LED-Chips (7, 7') zugewandte Seite der Lichtmischkammer (40)
- reflektierend oder
- reflektierend und streuend ausgeführt ist, und die Lichtmischkammer (40) durch eine Streuscheibe (90) abgedeckt oder offen ist.

2. LED-Strahler nach Anspruch 1,
wobei der Reflektorboden (60) eine zentrale Öffnung aufweist, durch die die LED-Chips (7, 7') ausgehend von dem unterhalb des Reflektorbodens (60) angeordneten Trägers (6) des LED-Moduls (5) in die Lichtmischkammer (40) ragen.

3. LED-Strahler nach Anspruch 1 oder 2,
wobei sich von dem Reflektorboden (60) ein vorzugsweise einstückig damit ausgebildeter Zylinderansatz (4°) wegerstreckt, der die Lichtmischkammer (40) umgibt.

4. LED-Strahler nach einem der vorhergehenden Ansprüche,
**dadurch gekennzeichnet, daß** die Lichtmischkammer (40) und der Reflektor (2) auf dem Träger (6) des LED-Moduls (5) aufgesetzt sind.

5. LED-Strahler nach Anspruch 1 oder 2,
**dadurch gekennzeichnet, daß** die Lichtmischkammer (40) und der Reflektor (2) separat oder integriert ausgestaltet sind.

6. LED-Strahler nach einem der vorhergehenden Ansprüche,
**dadurch gekennzeichnet, daß** die LED-Chips (7, 7') mit einer Farbkonversionsschicht (8) abgedeckt sind.

7. LED-Strahler nach einem der vorhergehenden Anprüche,
**dadurch gekennzeichnet, daß** die LED-Chips (7, 7') mit einem bspw. durch ein Dispensverfahren aufgebrachten Globe-Top (8) oder einer anderen Abdeckung abgedeckt sind.

8. LED-Strahler nach einem der vorhergehenden Ansprüche,
**dadurch gekennzeichnet, daß** die LED-Chips (7, 7') monochromatische gleichfarbige oder verschiedenfarbig sind.

9. LED-Strahler nach einem der vorhergehenden Ansprüche,
**dadurch gekennzeichnet, daß** die LED-Chips (7, 7') aufweisend:
- wenigstens eine blaue oder UV LED aufweisen, deren Licht durch eine Farbkonversionsschicht (8), die oberhalb und vorzugsweise in direktem Kontakt mit sämtlichen LEDs (7, 7') angeordnet ist, teilweise in Licht mit anderer Wellenlänge umgesetzt wird, wobei das Mischlicht vorzugsweise im weissen Spektrum liegt, und
- wenigstens eine weitere LED, deren Licht im wesentlichen durch die Farbkonversionsschicht (8) nicht umgesetzt wird.

10. LED-Strahler nach einem der vorhergehenden Ansprüche,
**dadurch gekennzeichnet, daß** die innere Mantelfläche (70) des Reflektors (2) und/oder die Lichtmischkammer (40) einen parabolischen oder eine geradlinigen Verlauf aufweist oder wenigstens teilweise in Form von Facetten ausgebildet ist.

11. LED-Strahler nach einem der vorhergehenden Ansprüche,
**dadurch gekennzeichnet, daß** die innere Mantelfläche (70) des Reflektors (2) reflektierend und/oder streuend ausgebildet ist.

12. LED-Strahler nach einem der vorhergehenden Ansprüche,
**dadurch gekennzeichnet, daß** der Reflektorboden (60) und/oder die Grundfläche (50) der Mischkammer (40) kreisförmig, elliptisch oder quadratisch geformt ist.

13. LED-Strahler nach einem der vorhergehenden Ansprüche,
**dadurch gekennzeichnet, daß** der Reflektor (2) durch eine Streuscheibe (90, 100) abgedeckt oder offen ist.

14. LED-Strahler nach einem der vorhergehenden Ansprüche,
**dadurch gekennzeichnet, daß** die Lichtmischkammer (40) und/oder der Reflektor (2) durch eine Farbkonversionsscheibe abgedeckt sind.

15. LED-Strahler nach einem der vorhergehenden Ansprüche,
**dadurch gekennzeichnet, daß** er als Deckenstrahler zum Einbau in abgehängten Decken ausgebildet ist.

16. LED-Strahler nach einem der vorhergehenden Ansprüche,
**dadurch gekennzeichnet, daß** er als Retrofit LED-Reflektor Lampe ausgebildet ist und bspw. mit einer handelsüblichen Fassung wie bspw. E27, E14 etc. ausgerüstet ist.

17. LED-Strahler nach einem der vorhergehenden Ansprüche,
**dadurch gekennzeichnet, daß** der Kühlkörper (3) eine zentrale Vertiefung zur Aufnahme des LED-Moduls (5) aufweist.

18. LED-Strahler einem der vorhergehenden Ansprüche,
**dadurch gekennzeichnet, daß** der Kühlkörper (3) vorzugsweise in Form von Kühlrippen der Aussenseite des Reflektors (2) wenigstens teilweise in flächigem Kontakt folgt.

19. Verfahren zur Verbesserung der Farbhomogenität eines Weisslicht LED-Strahlers, aufweisend die Schritte:
- Vormischung von Licht von mehreren LEDs und optional von Farbkonversionsmaterial in einer von reflektierenden Wänden seitlich begrenzten und zum Teil nicht gefüllten Lichtmischkammer (40), wobei die den LED-Chips (7, 7') zugewandte Seite der Lichtmischkammer (40)
- reflektierend oder
- reflektierend und streuend
ausgeführt ist,
- Leiten des Lichts aus der offenen oder durch eine Streuscheibe (40) abgedeckten Lichtmischkammer (40) in das Innenvolumen eines Reflektors (2), der das Licht an seiner Austrittsseite ausgibt.

## Claims

1. LED spotlight, preferably for white light, having:
- a LED module (5) with several LED chips (7, 7') on a support (6),
- a cooling element (3) being in thermal contact with the LED module (5),
- a reflector (2) laterally surrounding the LED chips (7, 7'), and
- a light mixing chamber (40), laterally surrounding the LED chips (7, 7') and arranged within the reflector (3),
wherein the light mixing chamber base area (50) and the reflector bottom (60) are on the same level, the side of the light mixing chamber (40) facing the LED chips (7, 7') is configured to be
- reflective or
- reflective and diffusive
and the light mixing chamber (40) is covered by a diffusion disk (90) or open.

2. LED spotlight according to claim 1, wherein the reflector bottom (60) has a central opening, through which the LED chips (7, 7') protrude into the light mixing chamber (40) coming from the LED module's (5) support (6) arranged underneath the reflector bottom (60).

3. LED spotlight according to claim 1 or 2, wherein from the reflector bottom (60) a preferably therewith integrally formed cylinder attachment (4) extends away and surrounds the light mixing chamber (40).

4. LED spotlight according to one of the preceding claims, **characterized in that** the light mixing chamber (40) and the reflector (2) are placed on the support (6) of the LED module (5).

5. LED spotlight according to claim 1 or 2, **characterized in that** the light mixing chamber (40) and the reflector (2) are configured to be separate or integrated.

6. LED spotlight according to one of the preceding claims, **characterized in that** the LED chips (7, 7') are covered by a color conversion layer (8).

7. LED spotlight according to one of the preceding claims, **characterized in that** the LED-Chips (7, 7') are covered by a Globe-top (8), applied by a dispensing method for instance, or a different cover.

8. LED spotlight according to one of the preceding claims, **characterized in that** the LED chips (7, 7') are monochromatic of the same color or of different colors.

9. LED spotlight according to one of the preceding claims, **characterized in that** the LED chips (7, 7') have:
- at least one blue or UV LED whose light is converted partially into light with a different wavelength by a color conversion layer (8) that is arranged above and preferably in direct contact with all LEDs (7, 7'), wherein the mixed light is preferably in the white spectrum, and
- at least one more LED whose light is essentially not converted by the color conversion layer (8).

10. LED spotlight according to one of the preceding claims, **characterized in that** the interior lateral surface (70) of the reflector (2) and/or the light mixing chamber (40) has a parabolic or a straight-lined run or is at least partially configured in the form of facets.

11. LED spotlight according to one of the preceding claims, **characterized in that** the interior lateral surface (70) of the reflector (2) is configured to be reflective and/or diffusive.

12. LED spotlight according to one of the preceding claims, **characterized in that** the reflector bottom (60) and/or the base area of the mixing chamber (40) is circular, elliptical or square-shaped.

13. LED spotlight according to one of the preceding claims, **characterized in that** the reflector (2) is covered by a diffusion disk (90, 100) or open.

14. LED spotlight according to one of the preceding claims, **characterized in that** the light mixing chamber (40) and/or the reflector (2) are covered by a color conversion disk.

15. LED spotlight according to one of the preceding claims, **characterized in that** it is configured as ceiling spotlight to be installed in suspended ceilings.

16. LED spotlight according to one of the preceding claims, **characterized in that** it is configured as Retrofit LED reflector lamp and equipped, for instance, with a commercially available socket such as E27, E14, etc.

17. LED spotlight according to one of the preceding claims, **characterized in that** the cooling element (3) has a central recess for receiving the LED module (5).

18. LED spotlight according to one of the preceding claims, **characterized in that** the cooling element (3) follows, preferably in the form of cooling fins, the external side of the reflector (2) at least partially in flat contact.

19. Method for improving the color homogeneity of a white light LED spotlight, having the steps:
- premixing the light of several LEDs and optionally the color conversion material in a light mixing chamber (40) laterally bounded by reflective walls and partially not filled, wherein the side of the light mixing chamber (40) facing the LED chips (7, 7') is configured to be
- reflective or
- reflective and diffusive,
- leading the light from the light mixing chamber (40), which is either open or covered by a diffusion disk (90), into the interior volume of a reflector (2) that outputs the light on its outlet side.

## Revendications

1. Projecteur à DEL, de préférence à lumière blanche, comportant :
- un module DEL (5) comportant plusieurs puces DEL (7, 7') sur un support (6),
- un corps de refroidissement (3) étant en contact thermique avec le module DEL (5),
- un réflecteur (2) entourant latéralement les puces DEL (7, 7'), et
- une chambre de mélange de lumière (40), entourant latéralement les puces DEL (7, 7') et disposée à l'intérieur du réflecteur (3),
dans lequel la zone de base (50) de la chambre de mélange de lumière et le fond du réflecteur (60) sont au même niveau, le côté de la chambre de mélange de lumière (40) faisant face aux puces DEL (7, 7') est configuré pour être
- réfléchissant ou
- réfléchissant et diffusif
et la chambre de mélange de lumière (40) est couverte par un disque de diffusion (90) ou est ouverte.

2. Projecteur à DEL selon la revendication 1, dans lequel le fond du réflecteur (60) possède une ouverture centrale à travers laquelle les puces DEL (7, 7') dépassent dans la chambre de mélange de lumière (40) provenant du support (6) du module DEL (5) disposé en dessous du fond du réflecteur (60).

3. Projecteur à DEL selon les revendications 1 ou 2, dans lequel à partir du fond du réflecteur (60) se développe en éloignement un attache cylindrique (4) de préférence intégralement constitué avec celui-ci, qui entoure la chambre de mélange de lumière (40).

4. Projecteur à DEL selon l'une des revendications précédentes, **caractérisé en ce que** la chambre de mélange de lumière (40) et le réflecteur (2) sont placés sur le support (6) du module DEL (5).

5. Projecteur à DEL selon les revendications 1 ou 2, **caractérisé en ce que** la chambre de mélange de lumière (40) et le réflecteur (2) sont configurés pour être séparés ou intégrés.

6. Projecteur à DEL selon l'une des revendications précédentes, **caractérisé en ce que** les puces DEL (7, 7') sont couvertes d'une couche de conversion de couleur (8).

7. Projecteur à DEL selon l'une des revendications précédentes, **caractérisé en ce que** les puces DEL (7, 7') sont couvertes par un Globe-Top (8), appliqué, par exemple, par un procédé de distribution, ou un recouvrement différent.

8. Projecteur à DEL selon l'une des revendications précédentes, **caractérisé en ce que** les puces DEL (7, 7') sont monochromatiques de la même couleur ou de différentes couleurs.

9. Projecteur à DEL selon l'une des revendications précédentes, **caractérisé en ce que** les puces DEL (7, 7') comportent :
- au moins une DEL bleue ou UV dont la lumière est convertie partiellement en une lumière ayant une longueur d'onde différente par une couche de conversion de couleur (8) étant disposée au-dessus et de préférence en contact direct avec l'ensemble des DEL (7, 7'), dans lequel la lumière mélangée est de préférence dans le spectre de blanc, et
- au moins une DEL supplémentaire dont la lumière est substantiellement non convertie par la couche de conversion de couleur (8).

10. Projecteur à DEL selon l'une des revendications précédentes, **caractérisé en ce que** la surface latérale intérieure (70) du réflecteur (2) et/ou la chambre de mélange de lumière (40) possède un cours parabolique ou rectiligne ou est au moins partiellement configurée sous forme de facettes.

11. Projecteur à DEL selon l'une des revendications précédentes, **caractérisé en ce que** la surface latérale intérieure (70) du réflecteur (2) est configurée pour être réfléchissante et/ou diffusive.

12. Projecteur à DEL selon l'une des revendications précédentes, **caractérisé en ce que** le fond du réflecteur (60) et/ou la zone de base (50) de la chambre de mélange (40) a une forme circulaire, elliptique ou carrée.

13. Projecteur à DEL selon l'une des revendications précédentes, **caractérisé en ce que** le réflecteur (2) est couvert par un disque de diffusion (90, 100) ou est ouvert.

14. Projecteur à DEL selon l'une des revendications précédentes, **caractérisé en ce que** la chambre de mélange de lumière (40) et/ou le réflecteur (2) sont couverts par un disque de conversion de couleur.

15. Projecteur à DEL selon l'une des revendications précédentes, **caractérisé en ce qu'**il est configuré comme un projecteur à plafond à installer sur des plafonds suspendus.

16. Projecteur à DEL selon l'une des revendications précédentes, **caractérisé en ce qu'**il est configuré comme une lampe-réflecteur à DEL Retrofit et est équipé, par exemple, d'une douille disponible sur le marché telle que E27, E14, etc.

17. Projecteur à DEL selon l'une des revendications précédentes, **caractérisé en ce que** le corps de refroidissement (3) possède un renfoncement central pour recevoir le module DEL (5).

18. Projecteur à DEL selon l'une des revendications précédentes, **caractérisé en ce que** le corps de refroidissement (3) suit, de préférence sous forme d'ailettes de refroidissement, le côté extérieur du réflecteur (2) au moins partiellement en contact plat.

19. Procédé destiné à améliorer l'homogénéité de la couleur d'un projecteur à DEL à lumière blanche, comportant les étapes suivantes :
- prémélanger la lumière de plusieurs DEL et éventuellement le matériau de conversion de couleur dans une chambre de mélange de couleur (40) latéralement délimitée par des parois réfléchissantes et partiellement non remplie, dans lequel le côté de la chambre de mélange de lumière (40) faisant face aux puces DEL (7, 7') est configuré pour être
- réfléchissant ou
- réfléchissant et diffusif,
- amener la lumière de la chambre de mélange de lumière (40), étant soit ouverte ou couverte par un disque de diffusion (90), dans le volume intérieur d'un réflecteur (2) qui ressort la lumière par son côté de sortie.
